# EUROPEAN PATENT APPLICATION

(11) **EP 0 669 654 A1**
(43) Date of publication of application: **30.08.1995**
(21) Application number: 95301042.8
(22) Date of filing: 17.02.1995
(51) Int. Cl.: H01L 27/11, H01L 27/102

(54) **Memory cell**

(30) Priority: 24.02.1994 GB 9403503
(71) Applicant: SGS-THOMSON MICROELECTRONICS LTD., Bristol BS12 4SQ (GB)
(72) Inventor: List, Frans Jacob, c/o SGS-Thomson Microelec. Srl., I-95121 Catania, Sicily (IT)
(74) Representative: Palmer, Roger

(57) **Abstract**

A signal storing latch comprises first and second semiconductor regions of one type with a third region of semiconductor of opposite type located between them, thereby providing two back to back junctions, the second region being at a floating potential while voltage supplies to the first and third regions reverse bias one of the back to back junctions, the spacing of the junctions being such that when a similar input is applied to the first and second regions the second junction becomes reverse biased and punchthrough occurs to hold the potential of the second region at the voltage supplied to the first region.

## Description

The invention relates to a memory cell and particularly to latch devices for use in a memory cell.

Memory cells such as static RAM cells require a bistable storage device. This is commonly achieved by using cross-coupled inverters which are known as a latch.

Known bistable elements used in memory cells have commonly been based on two inverter circuits each using two transistors connected in series. The use of four transistors in such a conventional inverter arrangement occupies a substantial area of semiconductor. To reduce the area taken other known proposals have based a memory cell on two inverter circuits each using a resistor in series with a transistor. The area can thereby be reduced by formation of the resistors in a different layer of semiconductor device overlying the transistor with which it is connected. Although such a cell has only two transistors and occupies less area it has greater power consumption due to the replacement of transistors by resistors which continue to permit current flow.

It is an object of the present invention to provide improved latch devices which may be used in a memory cell. In particular it is an object of the invention to provide an improved latch device which requires less semiconductor area for each cell.

The invention provides a semiconductor latch device for storing an input voltage signal, which latch device comprises first and second semiconductor regions of one type with a third region of semiconductor of opposite type located between the first and second regions to provide first and second back to back junctions, a first voltage supply connected to said first region and a second voltage supply different from said first voltage supply connected to said third region to reverse bias said first junction, said second region being at a floating potential and said first and second junctions being spaced such that when an input similar to said first voltage supply is applied to said second region, said second junction is reverse biased and punch through occurs to hold the floating potential of the second region at the voltage supplied to the first region.

Preferably said input circuitry includes a gate controlled input.

Said junctions may be formed in a MOS device. Alternatively they may be formed in a bipolar device.

The invention includes a bistable storage device comprising two latch devices as aforesaid, a first latch device comprising an NPN device and the second device comprising a PNP device, said second region of each device being connected to a common storage node.

In one embodiment both said latch devices comprise MOS devices. In an alternative embodiment said latch devices may both comprise bipolar devices or one may be a bipolar device and the other a MOS device.

The invention includes a memory cell having a bistable storage device as aforesaid with access circuitry to permit read and write operation.

The invention includes an SRAM memory comprising a plurality of memory cells having bistable storage devices as aforesaid.

The invention also provides a method of storing data in a bistable storage device comprising a first PNP junction device 13d a second NPN junction device each of said devices having an input connected to input circuitry and outputs connected to a storage node, inputting a voltage value to said devices and causing one of said devices to effect punchthrough thereby storing at said storage node the voltage value input to said devices.

Some embodiments of the invention will now be described by way of example and with reference to the accompanying drawings in which:
Figure 1 is a schematic view of a prior art bistable storage device with access transistors,
Figure 2a shows a known NPN semiconductor device,
Figure 2b shows the device of Figure 2A with different voltage applied,
Figure 3a shows an NPN device in accordance with the present invention,
Figure 3b shows a PNP device in accordance with the present invention,
Figure 4 shows a bistable storage device in accordance with the present invention, with an access transistor,
Figure 5 shows a semiconductor structure in accordance with the example shown in Figure 4, omitting the access transistor,
Figure 6 is a circuit diagram of the device shown in Figure 5, with an access transistor,
Figure 7 shows an alternative semiconductor structure in accordance with the present invention, omitting the access transistor,
Figure 8 is a circuit diagram of the device shown in Figure 7, with an access transistor,
Figure 9 shows a further semiconductor structure in accordance with the present invention, with an access transistor integrated in the structure,
Figure 10 shows a further semiconductor structure in accordance with the present invention with an access transistor integrated in the structure, and
Figure 11 shows an SRAM device for use with memory cells in accordance with the present invention.

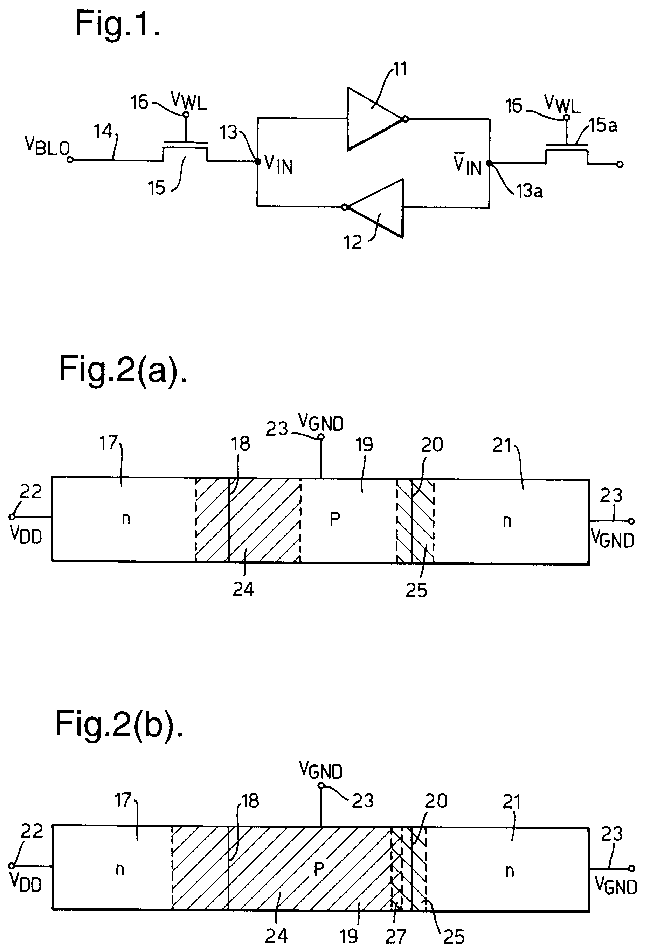

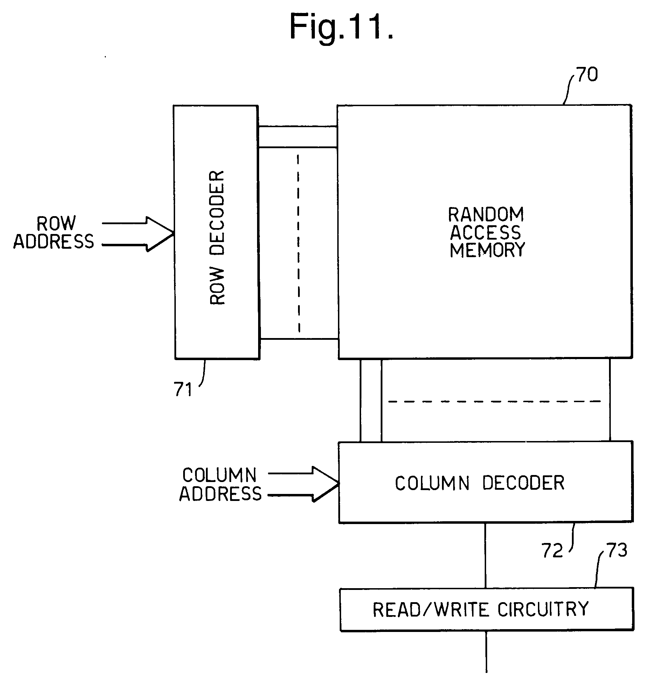

Figure 1 illustrates a known bistable storage device for use in a memory cell. Two cross-coupled inverters 11 and 12 form a bistable storage element. To control access to the storage element a node 13 is coupled to a bit line 14 through a pass gate transistor 15. The gate of transistor 15 is connected to a wordline 16 of a static RAM memory of the type shown in Figure 11. In this way a voltage Vin is input to the cell. A further node 13a stores a voltage Vin and this may provide an output through a pass gate transistor 15a.

The examples of the present invention make use of the phenomenon of punchthrough which causes current flow between two back to back semiconductor junctions. This will be explained with reference to Figures 2a and 2b. Figure 2a shows a known semiconductor device having a first N-type region 17 forming a first junction 18 with a P-type region 19. The P-type region 19 forms a second junction 20 with a second N-type region 21. In this way the two junctions 18 and 19 are arranged back to back. The first region 17 is connected to a voltage supply VDD at terminal 22 and the second N-type region 21 is connected to ground at 23. The P-type region 19 is also connected to ground at 23. It is known that the reverse bias across a junction between semiconductors of different types causes a depletion layer adjacent the junction. Junction 18 shown in Figure 2a has a depletion area marked by cross-hatching at 24. A smaller depletion layer 25 exists adjacent the second junction 20. It is known that the depletion layer increases as the reverse bias across such a junction is increased. In the example shown in Figure 2a it is junction 18 which is subjected to the reverse bias and for this reason the depletion zone 24 is much greater than region 25. In the operation of conventional transistors the doping of the different semiconductor regions together with their physical size is arranged that during normal range of operation the depletion layers adjacent junctions 18 and 20 do not meet. This is to avoid current flow directly from first region 17 to the region 21. Figure 2b shows the position when the input voltage on terminal 22 is increased to a higher level so as to increase the reverse bias across junction 18. In this case the depletion region 24 due to the reverse bias across junction 18 has extended considerably due to the increased voltage applied at terminal 22 although little change occurs in the depletion layer adjacent the junction 20. The extension of the depletion layer 24 is so great that it now overlaps depletion layer 25 and forms the overlapping region marked 27 in Figure 2b. This overlap of the two depletion layers is known as punchthrough and current may flow from region 17 to region 21. Normally this is avoided in conventional transistor operation.

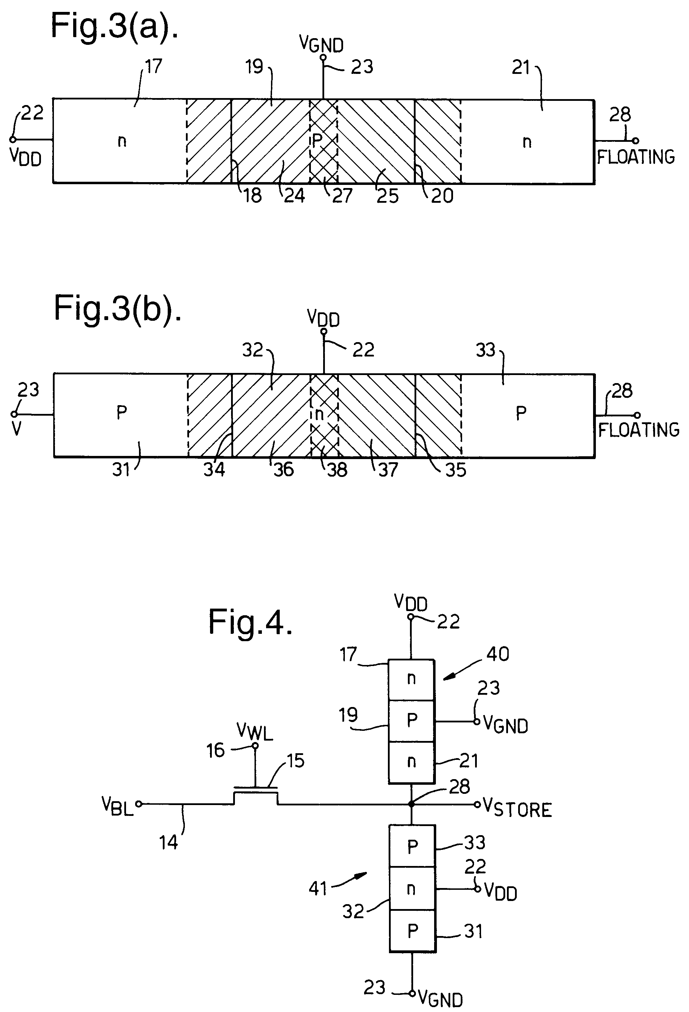

In the arrangement shown in Figure 3a a latch device is formed in accordance with the present invention. In this case similar reference numerals have been used as those in Figures 2a and 2b. However in this case the ground terminal 23 is connected to the P region 19 and the second N-type region 21 is connected to a floating output line 28.

The positive voltage supply VDD is applied to the first N-type region 17. The doping of the regions 17, 19 and 21 as well as their physical size is arranged such that when a positive voltage VDD is applied to the floating terminal 28 punchthrough occurs due to the creation of an extended depletion zone 25 adjacent junction 20. The depletion zone 24 adjacent junction 18 was already created by the reverse bias across junction 18 but the application of a positive voltage VDD to the floating terminal 28 causes a similar depletion layer 25 to extend from the reverse biased junction 20 so as to cause the overlap in the region marked 27. This allows current to flow from the input terminal 22 to the floating terminal 28 maintaining the floating terminal 28 at the voltage VDD even when the signal which had been input to the floating terminal 28 is removed. It will be understood that when punchthrough first occurs the floating region 21 is charged to the same potential as the input 22 and this rise in voltage in region 21 increases the reverse bias of junction 20 thereby extending and maintaining the overlapping depletion regions. Figure 3b shows a similar arrangement for a PNP device. In this case the first P-type region 31 is connected to the ground terminal 23, the supply voltage VDD from terminal 22 is connected to the middle N-type region 32 and the second P-type region 33 is connected to a floating terminal 28. In this case junction 34 between regions 31 and 32 is reverse bias thereby causing a depletion layer 36 similar to that previously described for region 24 in Figure 3a. If ground potential is applied to the floating terminal 28 this will cause junction 35 to be come reverse biased thereby establishing a second depletion layer 37. The doping and size of the semiconductor regions is such that as the potential on the floating terminal 28 is brought down towards the ground, punchthrough occurs as a result of overlapping at 38 of the two depletion layers 36 and 37. This then causes a charge flow to the ground terminal 23 increasing the extent of reverse bias on junction 35 thereby maintaining the device in the punchthrough condition even when ground potential is removed from the floating terminal 28 and it resumes a floating condition. It will therefore be appreciated that in the PNP device of Figure 3b the floating terminal 28 is capable of latching a value 0 which is input to it in order to create the punchthrough condition. Similarly in Figure 3a the floating terminal 28 may be used to latch a value 1 when a positive voltage is applied to it to establish punchthrough.

Figure 4 shows a bistable storage device incorporating the two latch elements of Figures 3a and 3b. Device 40 is the same as that shown in Figure 3a and device 41 is the same as that shown in Figure 3b. Similar reference numerals have been used for parts corresponding to those already described. The two devices 40 and 41 are connected with their output lines connected to a common storage node 28. The inputs to both devices are connected to a bit line 14 through a pass gate transistor 15 similar to that already described with reference to Figure 1. The output of the transistor 15 is applied to the floating node 28 connected to each of the devices 40 and 41. It will be appreciated that if the output of the pass transistor 15 represents 0 by applying ground voltage to node 28 then device 41 will be subject to punchthrough as previously described with reference to Figure 3b and the storage node 28 will hold a value 0. If on the other hand the signal from the bit line is 1 then the floating node 28 will have an increasing positive voltage applied which will cause no punchthrough in device 41 but punchthrough will occur in device 40 thereby allowing VDD applied to the N region 17 to hold the output node 28 at a value of 1. It will be appreciated that the value 0 or 1 taken up by the storage node 28 will be maintained by the punchthrough condition even when the pass transistor 15 is switched off thereby removing the input signal derived from the bit line. Similarly to access the device for a read operation the pass transistor may output on the bit line 14 the voltage level held on the storage node 28.

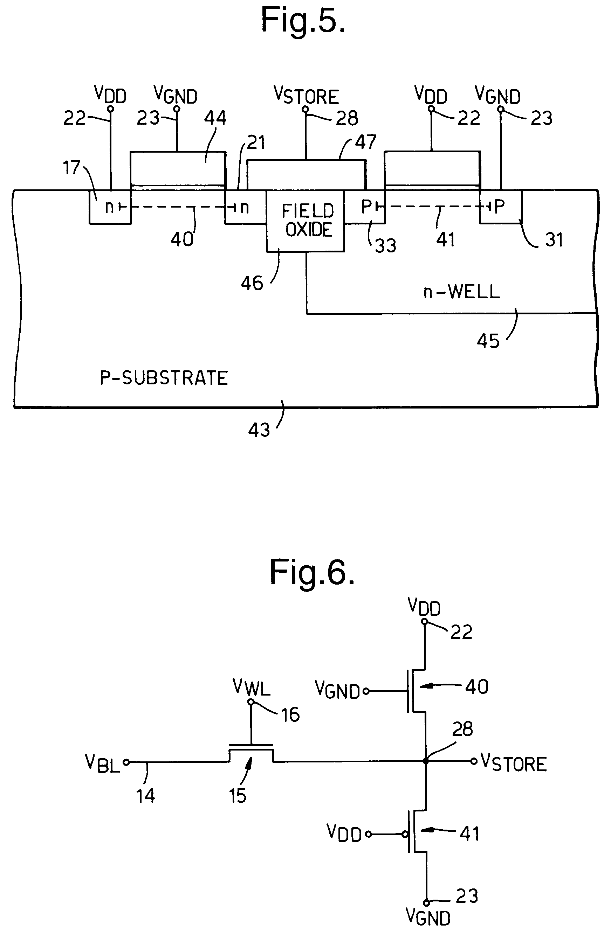

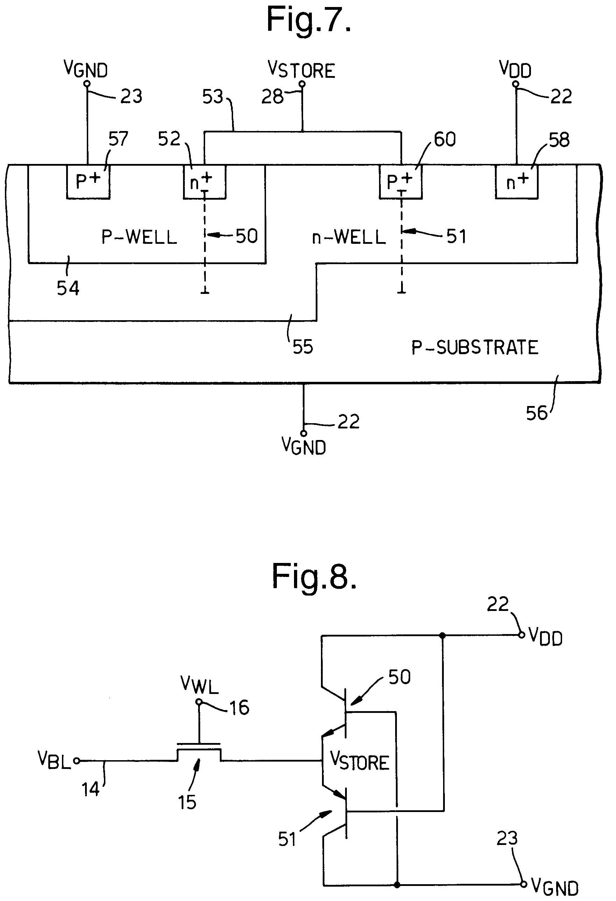

The structure of a CMOS implementation of the device of Figure 4 is shown in more detail in Figure 5. Device 40 is formed by two N-type regions 17 and 21 in a P-type substrate 43. The device 40 is a CMOS FET controlled by a gate 44 connected to the ground terminal 23. The dotted line marked 40 indicates the line of punchthrough when this occurs. Device 41 is formed by two P-type regions 31 and 33 spaced apart in a N-well 45. The regions 21 and 33 are separated by field oxide 46 and an interconnect 47 over that field oxide interconnects regions 21 and 33 with the output node for storing signals entered into the latch. The operation of the two devices 40 and 41 are the same as that already described with reference to Figure 4. The circuit diagram of the CMOS transistors of Figure 5 is shown in Figure 6 together with the pass transistor 15 controlling input of data from the bit line 14. A bipolar implementation is shown in more detail in Figure 7. In this example the NPN transistor is indicated at 50 and the PNP transistor is marked 51. Transistor 50 has an N region 52 connected through the interconnect 53 to the floating node 28. Region 52 is formed in a P-well 54 formed in an N-well 55. Both wells are formed in a P-substrate 56. The P-well 54 is maintained at ground potential by virtue of a P region 57 connected to the ground line 23. The N-well 55 is maintained at a positive voltage by an N region 58 connected to the positive voltage supply 22. The second transistor 51 comprises a P region 60 connected to the floating node 28, an N region in the well 55 and a P region formed by the substrate 56 which is connected to the ground terminal 22. The circuit formed by this device is shown in Figure 8. It will be appreciated that the two bipolar transistors 50 and 51 will be subjected to punchthrough of one or other of the transistors in a manner previously described when the floating node 28 is either moved towards ground potential to store 0 or has an applied positive voltage to store 1.

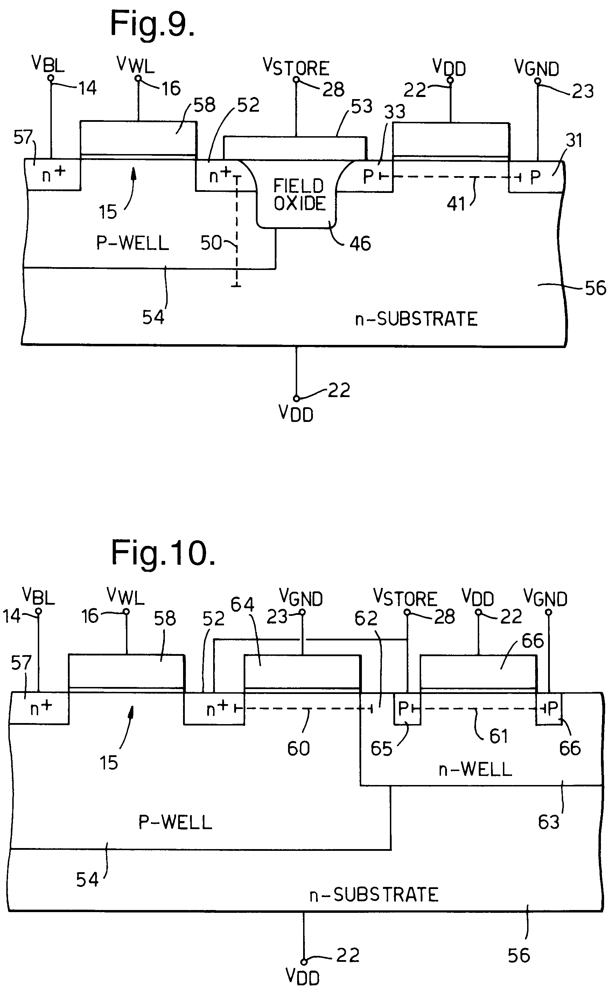

Figure 9 shows a structure of a further implementation where transistor 50 comprises a bipolar NPN transistor similar to that described in Figure 7 and transistor 41 comprises a PNP transistor similar to that described in Figure 5. In the case of the transistor 41 the punchthrough occurs in a horizontal direction between the two P regions 31 and 33. The N region is provided by a substrate of N-type material 56 connected to the positive voltage supply 22. The operation of transistor 41 is exactly the same as that described in Figure 5. The transistor is separated from transistor 50 by a field oxide region 46. Transistor 50 has one N region marked at 52 and the other N region is provided by the N substrate 56. In this case the pass transistor 15 is formed in the P-well 54. It comprises an NPN MOS device having the bit line 14 connected to an N region 57 separated from the N region 52 by the P region provided by the well 54. Operation of the transistor 15 is controlled by a gate 58 coupled to the wordline 16. Punchthrough of the bipolar transistor 50 occurs in the vertical direction as indicated and as previously described for transistor 50 in Figure 7.

Figure 10 shows a further implementation using two MOS transistors 60 and 61 similar to the operation of transistors 40 and 41 in Figure 5. This arrangement does however provide a more compact arrangement in avoiding the need for the field oxide 46 provided in Figure 5. The pass transistor 15 is constructed in the same manner as that already described in Figure 9. However transistor 60 comprises a first N-type region 52 which is connected to the floating node 28. The P region is provided by the P-well 54 and the second N-type region is provided by a region 62 in a N-well 63. Operation of transistor 60 is controlled by a gate 64 connected to the ground terminal 23. The second transistor 61 consists of two P-type regions 65 and 66 formed in the N-well region 63 and controlled by a gate 66 coupled to the positive voltage supply 22. In this case both transistors 60 and 61 are CMOS devices arranged to exhibit punchthrough in the horizontal direction as indicated by the broken lines.

The bistable storage elements of the previous examples may be used in an SRAM of the type shown in Figure 11. In this case the SRAM 70 comprises a plurality of rows and columns of bistable storage devices of the type shown in any of the previous Figures 4 to 10. Access to the memory cells is controlled by a row decoder 71 and column decoder 72 in conventional manner. Read/write circuitry 73 is arranged to provide appropriate voltage signals on the floating nodes 28 during a write operation and to read the voltage signals latched onto the floating nodes during a read operation.

It will be appreciated that the storage elements of the above examples are advantageous in providing more compact structure for memory storage cells and may be used to reduce the number of transistors used. It will be appreciated that in each case a bistable cell has been provided by construction of only two transistors per cell and furthermore the physical size of those transistors may be reduced as the back to back junctions of each transistor may be located closer together in order to permit punchthrough to occur.

The invention is not limited to the details of the foregoing examples.

## Claims

1. A semiconductor latch device for storing an input voltage signal, which latch device comprises first and second semiconductor regions of one type with a third region of semiconductor of opposite type located between the first and second regions to provide first and second back to back junctions, a first voltage supply connected to said first region and a second voltage supply different from said first voltage supply connected to said third region to reverse bias said first junction, said second region being at a floating potential and said first and second junctions being spaced such that when an input similar to said first voltage supply is applied to said second region, said second junction is reverse biased and punchthrough occurs to hold the floating potential of the second region at the voltage supplied to the first region.

2. A semiconductor latch according to claim 1 in which a storage node is connected to said second region to hold in the latch the input voltage signal.

3. A semiconductor latch according to claim 1 or claim 2 in which a gate controlled access circuit is connected to said second region.

4. A semiconductor latch device according to any one of the preceding claims wherein said junctions are formed in a MOS device.

5. A semiconductor latch device according to any one of claims 1 to 3 wherein said junctions are formed in a bipolar device.

6. A bistable storage device comprising two latch devices each as claimed in any one of the preceding claims, a first latch device comprising an NPN device and the second device comprising a PNP device, said second region of each device being connected to a common storage node.

7. A bistable storage device according to claim 6 wherein both said latch devices comprises MOS devices.

8. A bistable storage device according to claim 6 in which at least one of said latch devices comprises a bipolar device.

9. A memory cell comprising a bistable storage device according to any one of claims 6 to 8 including access circuitry to permit read and write operation to said memory cell.

10. A memory cell according to claim 9 wherein said access circuitry includes a bit line, said bit line being connected to said first region.

11. An SRAM memory comprising a plurality of memory cells each as claimed in either claim 9 or claim 10.

12. A method of storing data in a bistable storage device comprising a first PNP junction device and a second NPN junction device each of said devices having an input connected to input circuitry and outputs connected to a storage node, inputting a voltage value to said devices and causing one of said devices to effect punchthrough thereby storing at said storage node the voltage value input to said devices.
